# EUROPEAN PATENT APPLICATION

(11) **EP 4 848 940 A1**
(43) Date of publication of application: **02.12.2026**
(21) Application number: 26182145.8
(22) Date of filing: 29.05.2026
(51) Int. Cl.: H10D 64/23, H10D 62/85, H10D 30/47, H10D 64/00, H10D 80/20

(54) **FIELD PLATE PLACEMENT FOR ENHANCING HARD SWITCHING PERFORMANCE OF A HIGH ELECTRON MOBILITY TRANSISTOR**

(30) Priority: 30.05.2025 US 202563814627 P; 09.04.2026 US 202619643609
(71) Applicant: Power Integrations, Inc., San Jose, CA 95138 (US)
(72) Inventor: Murukesan, Karthick, San Jose, 95135 (US); Yang, Kuo-Chang Robert, Campbell, 95008 (US)
(74) Representative: Fish & Richardson P.C.

(57) **Abstract**

A field plate pattern for enhancing hard switching performance of a HEMT (e.g., a GaN HEMT) is disclosed herein. There may be two or more field plates (e.g., strips of metallization) spaced apart laterally on a passivation layer; and the depth of one or more of the field plates may be patterned and/or staggered (i.e., adjusted, varied) to improve performance and to prevent trapped electrons. For instance, one of the laterally spaced field plates may have a first depth extending into the passivation layer while another may have a second depth, different from the first. Having variable depth, the field plates may advantageously allow an additional degree of freedom for realizing a robust GaN HEMT for hard switching applications without the need for adding additional fields and without the need for increasing device area.

## Description

### CROSS-REFERENCE TO RELATED APPLICATION(S)

This application claims the benefit of U.S. Provisional Application No. 63/814,627 filed on May 30, 2025 and of U.S. Non-Provisional Application No. 19/643,609 filed on April 9, 2026, incorporated by reference herein in their entirety.

### BACKGROUND INFORMATION

### Field of the Disclosure

The present invention relates to high-electron mobility transistors (HEMTs), and more specifically to a HEMT device with staggered field plates.

### Background

Gallium nitride (GaN) and other wide band-gap nitride III based direct transitional semiconductor materials exhibit high breakdown electric fields and avail high current densities. In this regard GaN based semiconductor devices are actively researched as an alternative to silicon based semiconductor devices in power and high frequency applications. For instance, a GaN HEMT may provide lower specific on resistance with higher breakdown voltage relative to a silicon power field effect transistor of commensurate area.

High electron mobility transistors (HEMTs) are fabricated to have, among other properties, a breakdown voltage that is predictable and stable. The fabrication of high voltage HEMTs may include special structures of conductive components surrounded by an electrically insulating material. The special structures of conductive components are often referred to as field plates.

The specific on resistance of a power device (e.g., a power FET) may refer to a resistance (i.e., on resistance) multiplied by device area. In this way specific on resistance offers a figure of merit relating to how much semiconductor area may be required to realize a desired value of on resistance.

The specific on resistance of a HEMT, and more specifically, a GaN HEMT, depends, in part, on the successful formation of a low-impedance two-dimensional electron gas within the structure (2DEG). Ideally, during the on-state (i.e., when the HEMT is "on"), the HEMT may support large current operation due, in part, to the low impedance 2DEG; and during the off-state (i.e., when the HEMT is "off"), the HEMT may support a large drain-to-source voltage and block (prevent) current.

During high voltage switching, a GaN HEMT may exhibit a dynamic increase in on resistance, often referred to as "current collapse", due in part to trapped electrons. When used in power converters, GaN HEMTs may be especially susceptible to current collapse during hard switching (i.e., switching during the simultaneous presence of transistor current and transistor voltage). For instance, when used as a switch in a power converter, a GaN HEMT will undergo hard switching when the power converter operates in continuous conduction mode (CCM).

Therefore, there is a fundamental need to not only develop higher voltage GaN HEMTs but also to improve existing GaN HEMTs for high power switching applications operating in CCM.

One way to reduce susceptibility to current collapse is to increase device size (area). For instance, additional field plates may be added to an existing structure thereby reducing susceptibility to current collapse at the expense of additional (lateral) area. Unfortunately, increasing device size may undesirably increase cost and specific on resistance. Therefore, there is a need to improve HEMT device structures without increasing area and without increasing cost.

### Summary of the Disclosure

This disclosure presents a field plate pattern for enhancing hard switching performance of a HEMT (e.g., a GaN HEMT). There may be two or more field plates (e.g., strips of metallization) spaced apart laterally on a passivation layer. According to the teachings herein, the depth of one or more of the field plates may be patterned and/or staggered (i.e., adjusted, varied) to improve performance and to prevent trapped electrons. For instance, one of the laterally spaced field plates may have a first depth extending into the passivation layer while another may have a second depth, different from the first. In this manner the field plates may become "staggered" by depth. The concept of adjusting depth may avail a new degree of freedom for improving the placement of laterally spaced field plates. Having variable depth, the field plates may advantageously allow an additional degree of freedom for realizing a robust GaN HEMT for hard switching applications without the need for adding additional fields and without the need for increasing device area.

### BRIEF DESCRIPTION OF THE DRAWINGS

Non-limiting and non-exhaustive embodiments of a field plate placement for enhancing hard switching performance of a high electron mobility transistor (HEMT) are described with reference to the following figures, wherein like reference numerals refer to like parts throughout the various views unless otherwise specified.
**FIG. 1A** illustrates a device cross section of a HEMT device structure according to the teachings herein.
**FIG. 1B** further illustrates a band diagram 150 relating to the formation of the two dimensional electron gas (2DEG) along the Y-direction.
**FIG. 2** illustrates a device cross section of a HEMT device structure according to an embodiment of the present disclosure.
**FIG. 3A** illustrates a device cross section of a HEMT device structure electrically coupled to a capacitance network according to an embodiment of the present disclosure.
**FIG. 3B** illustrates a device cross section of a HEMT device structure electrically coupled to both a capacitance network and a bias network according to another embodiment of the present disclosure.
**FIG. 4A** illustrates a device cross section of a HEMT device structure according to a first embodiment.
**FIG. 4B** illustrates a device cross section of a HEMT device structure according to a second embodiment.
**FIG. 4C** illustrates a device cross section of a HEMT device structure according to a third embodiment.
**FIG. 4D** illustrates a device cross section of a HEMT device structure according to a fourth embodiment.
**FIG. 5A** illustrates plots of lateral electric field corresponding with the embodiments of FIG. 4A through FIG. 4D.
**FIG. 5B** illustrates plots of vertical electric field corresponding with the embodiments of FIG. 4A through FIG. 4D.
**FIG. 5C** illustrates additional plots of vertical electric field corresponding with the embodiments of FIG. 4A through FIG. 4D.
**FIG. 6** illustrates plots of electron density corresponding with the embodiment of FIG. 4C.
**FIG. 7A** illustrates a device cross section of a HEMT device structure including additional passivation layers according to an embodiment of the present disclosure.
**FIG. 7B** illustrates a device cross section of a HEMT device structure including additional passivation layers according to another embodiment of the present disclosure.

Corresponding reference characters indicate corresponding components throughout the several views of the drawings. Skilled artisans will appreciate that elements in the figures are illustrated for simplicity and clarity and have not necessarily been drawn to scale. For example, the dimensions of some of the elements and layers in the figures may be exaggerated relative to other elements to help to improve understanding of various embodiments of the teachings herein. Also, common but well-understood elements, layers, and/or process steps that are useful or necessary in a commercially feasible embodiment are often not depicted in order to facilitate a less obstructed view of these various embodiments of a field plate placement for enhancing hard switching performance of a high electron mobility transistor (HEMT).

### DETAILED DESCRIPTION

In the following description, numerous specific details are set forth in order to provide a thorough understanding of a field plate placement for enhancing hard switching performance of a high electron mobility transistor (HEMT). It will be apparent, however, to one having ordinary skill in the art that the specific detail need not be employed to practice the teachings herein. In other instances, well-known materials or methods have not been described in detail in order to avoid obscuring the present disclosure.

Skilled artisans will appreciate that elements in the figures are illustrated for simplicity and clarity and have not necessarily been drawn to scale. For example, the dimensions of some of the elements in the figures may be exaggerated relative to other elements to help to improve understanding of various embodiments of the teachings herein. Although the following embodiments may present examples of GaN HEMTs whereby a two-dimensional electron gas forms between AlGaN and GaN layers, other materials allowing the formation of a two-dimensional electron gas may be possible. Thus, the teachings herein may also apply to any HEMT allowing the formation of a two-dimensional electron gas; and one may appreciate that the embodiments are presented as non-limiting examples of a HEMT with field plates patterned for enhancing performance during CCM.

As described above, there is a fundamental need to not only develop higher voltage GaN HEMTs but also to improve existing GaN HEMTs for high power switching applications operating in CCM. For instance, when used as a switch in a power converter (e.g., a flyback converter), a GaN HEMT should be robust to current collapse even under high stress switching conditions. Examples of high stress conditions may include continuous conduction mode (CCM); during CCM a GaN HEMT may hard switch a high voltage and a high current at the same time.

A field plate pattern for enhancing hard switching performance of a HEMT (e.g., a GaN HEMT) is disclosed herein. There may be two or more field plates (e.g., strips of metallization) spaced apart laterally on a passivation layer; and the depth of one or more of the field plates may be patterned and/or staggered (i.e., adjusted, varied) to improve performance and to prevent trapped electrons. For instance, one of the laterally spaced field plates may have a first depth extending into the passivation layer while another may have a second depth, different from the first. Having variable depth, the field plates may advantageously allow an additional degree of freedom for realizing a robust GaN HEMT for hard switching applications without the need for adding additional fields and without the need for increasing device area.

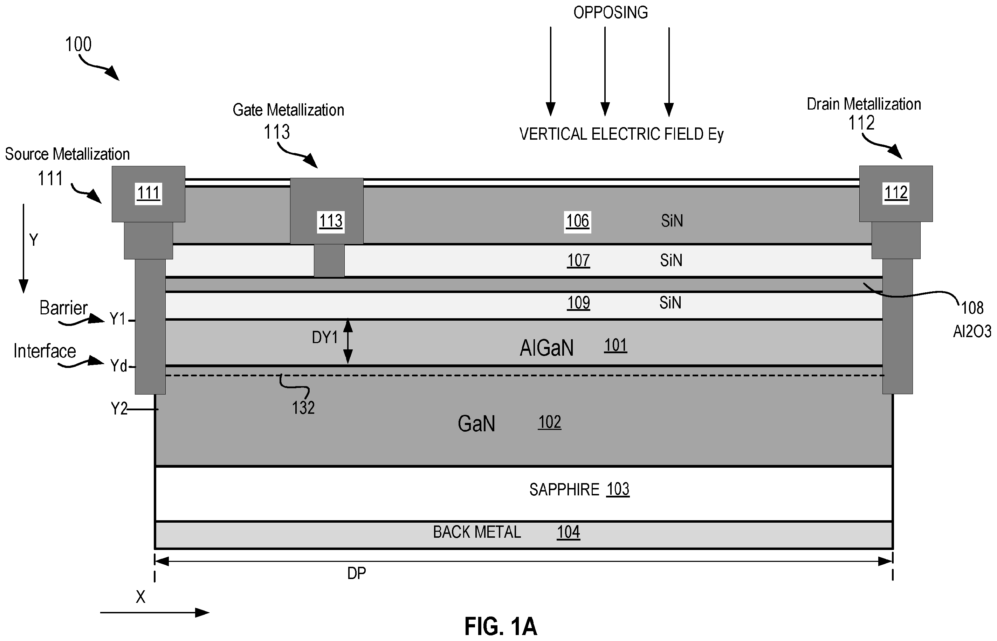

**FIG. 1A** illustrates a device cross section of a HEMT device structure 100 according to the teachings herein. The HEMT device structure 100 includes silicon nitride (SiN) layers 106, 107, and 109. SiN layers 106-107 may be formed using a plasma enhanced chemical vapor deposition (PECVD) process; and SiN layer 109 may be formed using a metal organic chemical vapor deposition (MOCVD) process. Also as illustrated, parallel channel HEMT device structure 100 includes an aluminum oxide (Al2O3) layer 108 between SiN layer 107 and SiN layer 109. Al2O3 layer 108 and SiN layer 109 may form a gate dielectric.

Parallel channel HEMT device structure 100 also includes an aluminum gallium nitride (AlGaN) layer 101, a gallium nitride (GaN) layer 102, a sapphire substrate 103, backmetal 104, source metallization 111, gate metallization 113, and drain metallization 112. Geometrically, the device cross section is a projection onto the XY-plane. In the X-direction (i.e., along the X-axis) the HEMT device structure 100 has a HEMT cell pitch DP given by the distance between the source metallization 111 and the drain metallization 112; and in the Y-direction (i.e., along the Y-axis) layers are formed.

As illustrated, the AlGaN layer 101 has a thickness DY1 (e.g., ten to thirty nanometers). Additionally, a two-dimensional electron gas (2DEG) 132 forms at or near an AlGaN/GaN interface Y-coordinate Yd. The source metallization 111 and the drain metallization 112 may be in electrical contact with the 2DEG 132. For instance, the source metallization 111 and the drain metallization 112 may each include a via extending past Y-coordinate Yd. Also, gate metallization 113 may include a via extending to the Al2O3 layer 108; and the AlGaN layer 101 may form a barrier at or near the AlGaN barrier Y-coordinate Y1.

According to the teachings herein, during hard switching, an opposing force to electrons from a two-dimensional electron gas (2DEG) 132 may be generated to reduce and/or to prevent hot carrier injection (HCI).

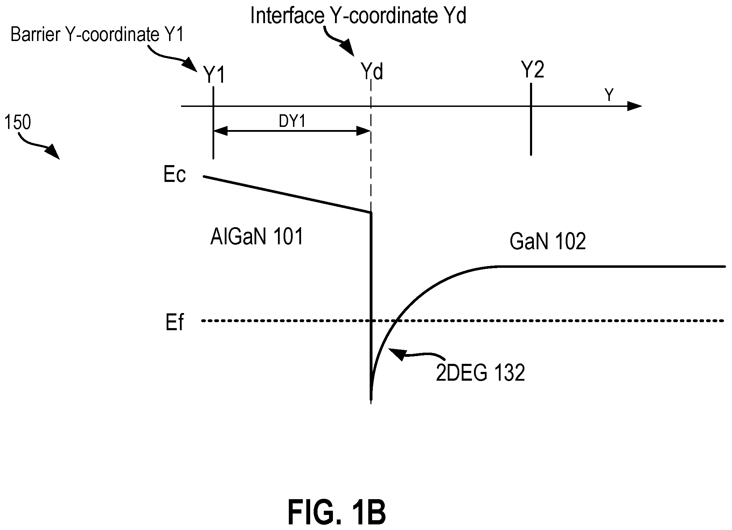

**FIG. 1B** further illustrates a band diagram 150 relating to the formation of the two 2DEG 132 along the Y-direction. Band diagram 150 illustrates the conduction band Ec and Fermi level Ef between barrier Y-coordinate Y1 and Y-coordinate Y2 within the GaN layer 102. According to the theory of heterojunctions, a 2DEG 132 forms where the Fermi level Ef is above (i.e, has energy larger than) the conduction band Ec.

The AlGaN layer 101 may be a relatively thin barrier layer of thickness DY1; and according to the theory of heterojunctions, hot carrier injection may occur when electrons from the 2DEG 132 overcome the thin barrier layer (AlGaN layer 101) and inject into layers above (e.g., into the Al2O3 layer 108). As described herein, during hard switching conditions, an opposing force to hot carrier injection (HCI) may be increased or enhanced by varying the depths of field plates.

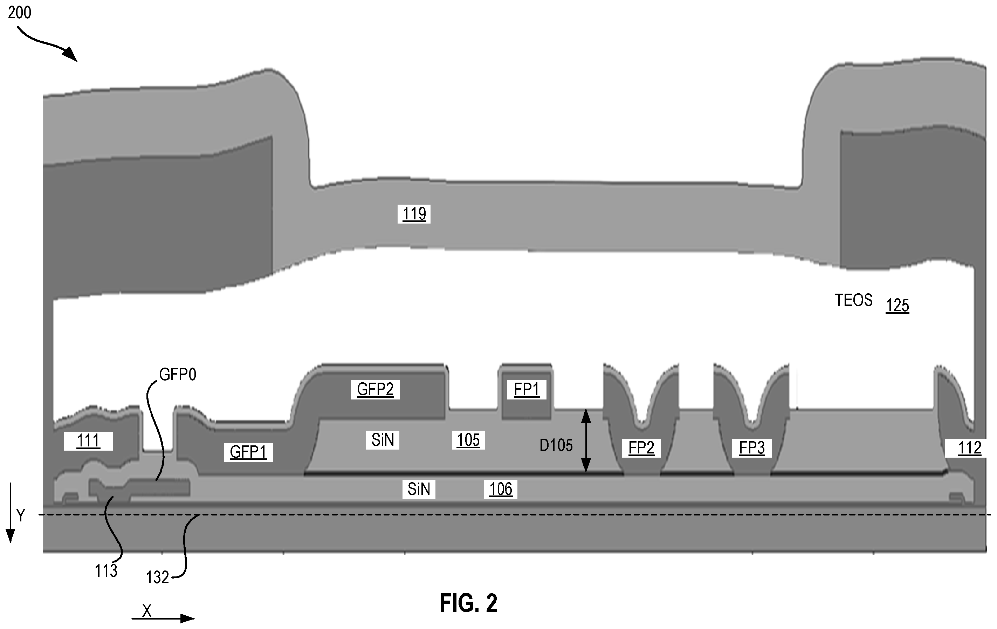

**FIG. 2** illustrates a device cross section of a HEMT device structure 200 according to an embodiment of the present disclosure. HEMT device structure 200 illustrates additional layers above the 2DEG 132; and common, well-understood elements and layers (e.g., GaN layer 101, AlGaN layer 102, Al2O3 layer 108, SiN layer 109) may not be depicted to facilitate a less obstructed view of field plate patterns.

The HEMT device structure 200 also has passivation layers including silicon nitride (SiN) layers 105, 106 and 119. SiN layers 105, 106, and 119 may be formed using a plasma enhanced chemical vapor deposition (PECVD) process and/or a metal organic chemical vapor deposition (MOCVD) process. SiN layer 105 is deposited above SiN layer 106 and may have a layer thickness D105. Tetraethyl orthosilicate (TEOS) layer 125 is deposited above SiN layer 106 as a silicon dioxide film using chemical vapor deposition (e.g., plasma enhanced chemical vapor deposition); and SiN layer 119 is deposited above TEOS layer 125.

As illustrated, source metallization 111 and drain metallization 112 may be in electrical contact with the 2DEG 132. For instance, source metallization 111 and drain metallization 112 may each include a via to make contact with the 2DEG 132. Additionally, source metallization 111 and drain metallization 112 may extend above SiN layers 105, 106 and above TEOS layer 125.

In addition to gate metallization 113, HEMT device structure 200 also includes gate field plates GFP0-GFP2 and field plates FP1-FP3. Gate field plate GFP0 is illustrated as being an extension of and in electrical contact with the gate metallization 113. Gate field plate GFP1 may be formed above gate field plate GFP0 and may extend to a surface of SiN layer 106. Gate field plate GFP2 is formed above gate field plate GFP1 and may extend to a surface of SiN layer 105; and gate field plate GFP2 is illustrated as being an extension of and in electrical contact with gate field plate GFP1. Although not illustrated, gate field plate GFP1 and gate field plate GFP2 may be in electrical contact with gate metallization 113. For instance, an interconnect (e.g., metal interconnect) may be used to connect gate metallization 113 to gate field plates GFP1, GFP2.

Also, as illustrated, field plates FP1-FP3 may be placed laterally (in the X-direction) between gate field plate GFP2 and drain metallization 112. According to the teachings herein, depth (in the Y-direction) of the field plates FP1-FP3 may be varied to prevent and/or reduce hot carrier injection (HCI) during hard switching operation. Field plate FP1 is placed with a first depth extending to the surface of SiN layer 105; and field plate FP2 and field plate FP3 both extend through SiN layer 105 to the surface of SiN layer 106. Therefore, rather than having all field plates FP1-FP3 extend to the same depth (e.g., to the surface of SiN layer 105), one or more may extend further by an amount determined by the layer thickness D105.

Additionally, field plates FP1, FP2, FP3 may be quasi-floating field plates whereby voltages (potentials) of each are determined by coupling to networks.

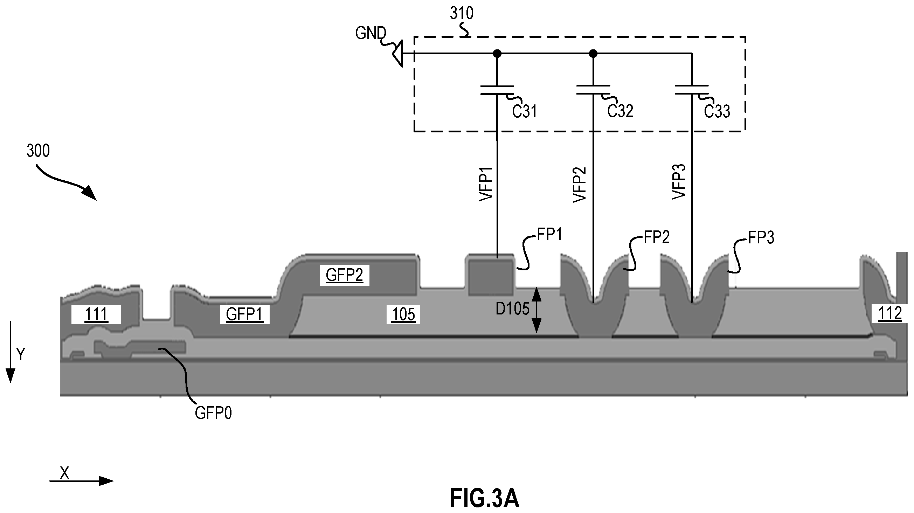

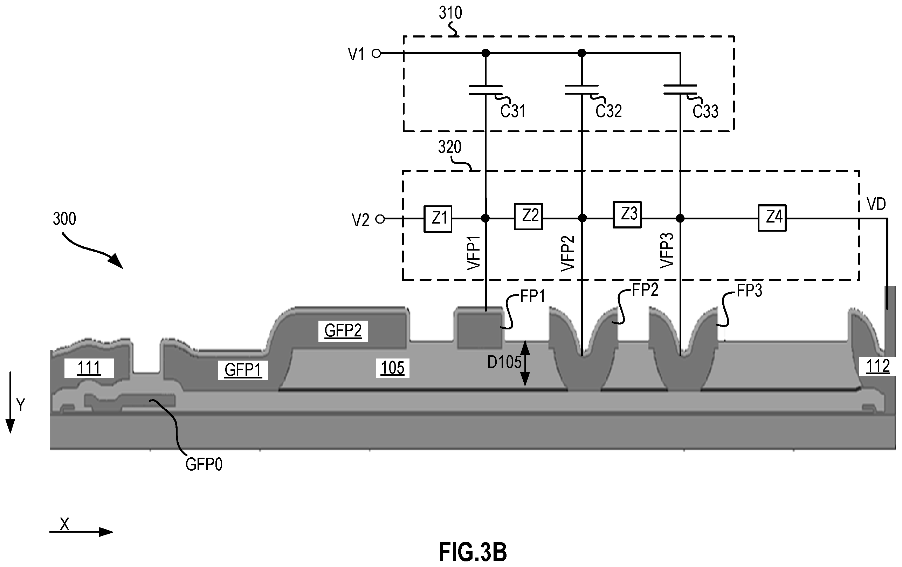

For instance, **FIG. 3A** illustrates a device cross section of a HEMT device structure 300 electrically coupled to a capacitance network 310; and **FIG. 3B** illustrated a device cross section of a HEMT device structure 300 electrically coupled to both a capacitance network 310 and a bias network 320. Capacitance network 310 includes capacitor C31, capacitor C32, and capacitor C33. Capacitors C31, C32, C33 may be realized with integrated and/or external capacitors. As illustrated, capacitors C31-C33 are electrically coupled between the field plates FP1-FP3 and ground GND. In this manner, field plate voltage VFP1, field plate voltage VFP2, and field plate voltage VFP3 may be controlled.

Bias network 320 includes impedance Z1, impedance Z2, impedance Z3, and impedance Z4. Impedances Z1, Z2, Z3, Z4 may be realized with integrated and/or external resistors, or alternatively, realized with active devices (e.g., N-channel depletion mode transistors). As illustrated, impedances Z1, Z2, Z3, Z4 may be electrically coupled together between the drain metallization 112 and a reference voltage V2; the drain metallization 112 may support a drain voltage VD.

Additionally, as illustrated, impedances Z1, Z2, Z3, Z4 may be electrically coupled to field plates FP1-FP3; and capacitors C31-C33 may be electrically coupled between the field plates FP1-FP3 and a reference voltage V1. Reference voltages may be selected to control and bias field plate voltages VFP1-VFP3. Having the field plates FP1-FP3 electrically coupled to either capacitance network 310, bias network 320, and/or to both, allows voltages VFP1-VFP3 to be controlled. Therefore, field plates FP1-FP3 may also be referred to as quasi-floating field plates FP1-FP3.

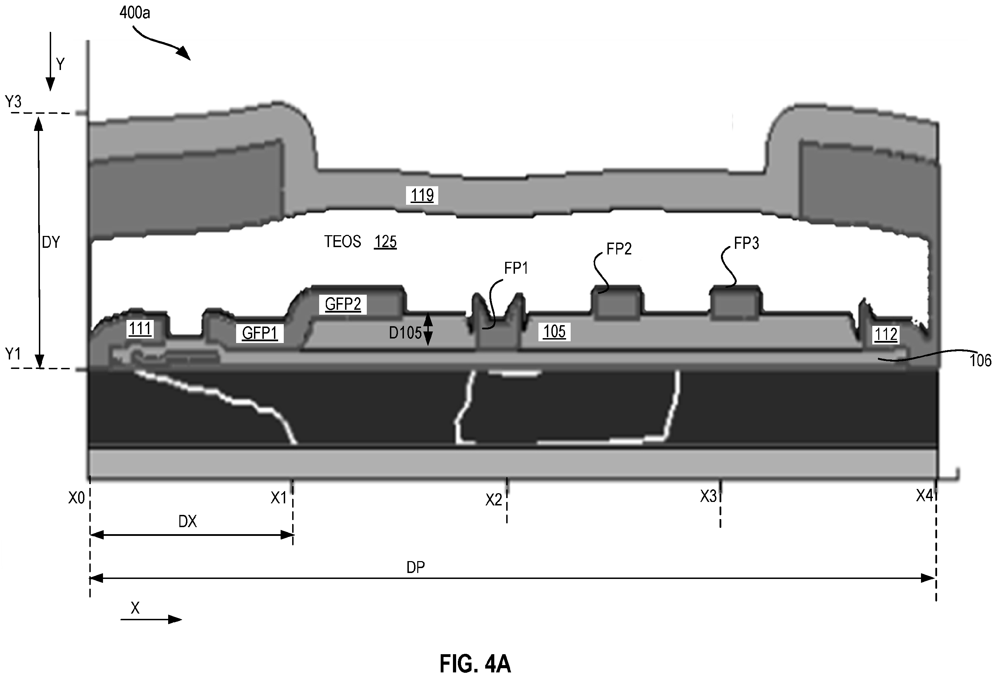

**FIG. 4A** illustrates a device cross section of a HEMT device structure 400a according to a first embodiment. In the Y-direction (along the Y-axis) the depth DY is shown as the distance between the barrier Y-coordinate Y1 and another Y-coordinate Y3 near the surface of the SiN layer 119. Depth DY may be between five and fifty microns (e.g., ten microns). In the X-direction (along the X-axis) X-coordinates X0-X4 are labelled between the source metallization 111 and the drain metallization 112. X-coordinate X0 may correspond with the position of the source metallization 111; and X-coordinate X4 may correspond with the position of the drain metallization 112. The distance between X-coordinate X0 and X-coordinate X4 is the cell pitch DP. The incremental lateral distance DX may be the distance between consecutive X-coordinates (e.g., between X-coordinate X0 and between X-coordinate X1). Lateral distance DX may be between five and fifty microns (e.g., ten microns).

As illustrated, field plate FP1 is placed deeper than field plates FP2-FP3. Field plates FP2-FP3 may extend to the surface of SiN layer 105. Field plate FP1 may extend deeper (e.g., by layer thickness D105) to the surface of SiN layer 106.

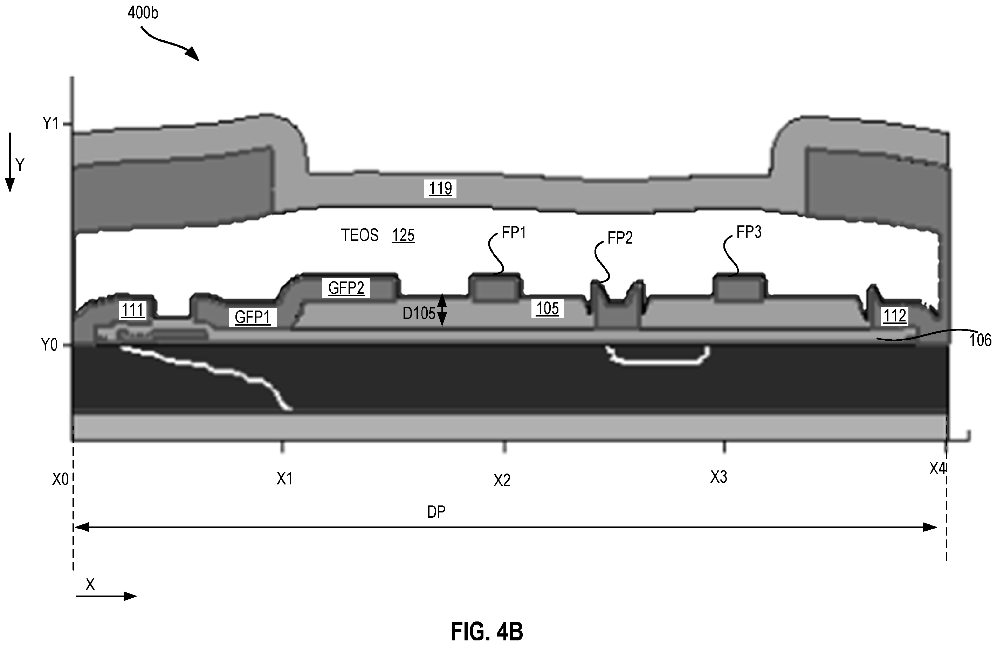

**FIG. 4B** illustrates a device cross section of a HEMT device structure 400b according to a second embodiment. Device structure 400b is like device structure 400a except field plate FP2 is placed deeper than field plates FP1, FP3. Field plates FP1, FP3 may extend to the surface of SiN layer 105; and field plate FP2 may extend deeper (e.g., by layer thickness D105) to the surface of SiN layer 106.

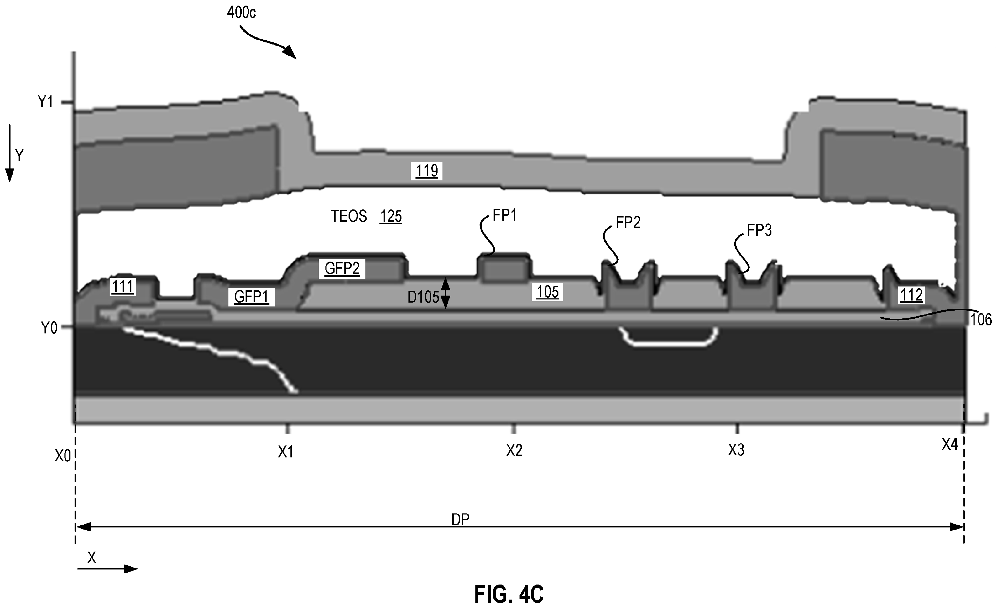

**FIG. 4C** illustrates a device cross section of a HEMT device structure 400c according to a third embodiment. Device structure 400c is like device structure 400a except field plates FP2, FP3 are placed deeper than field plate FP1. Field plates FP2, FP3 may extend deeper (e.g., by layer thickness D105) to the surface of SiN layer 106; and field plate FP1 may extend to the surface of SiN layer 105.

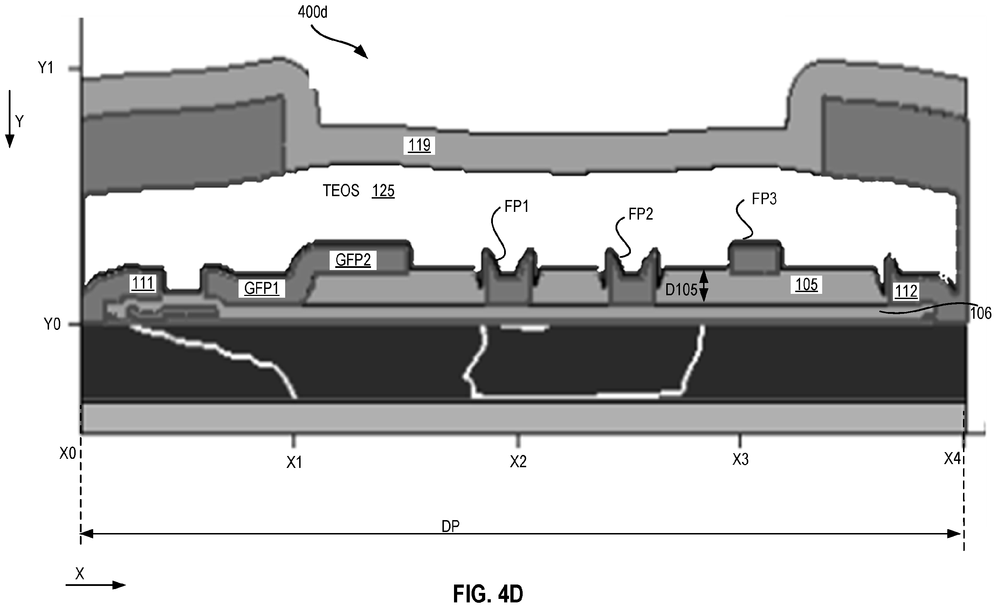

**FIG. 4D** illustrates a device cross section of a HEMT device structure 400d according to a fourth embodiment. Device structure 400d is like device structure 400a except field plates FP1, FP2 are placed deeper than field plate FP3. Field plates FP1, FP2 may extend deeper (e.g., by layer thickness D105) to the surface of SiN layer 106; and field plate FP3 may extend to the surface of SiN layer 105.

Although device structures 200, 300, 400a-d show embodiments having three field plates FP1-FP3, other device structures having greater or fewer than three are possible. For instance, a device structure may have two field plates FP1, FP2 which are placed at different depths. Moreover, although device structures 100, 200, 300, 400a-d present embodiments relating to an AlGaN/GaN heterojunction, the teachings herein may apply to other heterojunctions (e.g., aluminum gallium arsenide with gallium arsenide) giving rise to a 2DEG 132.

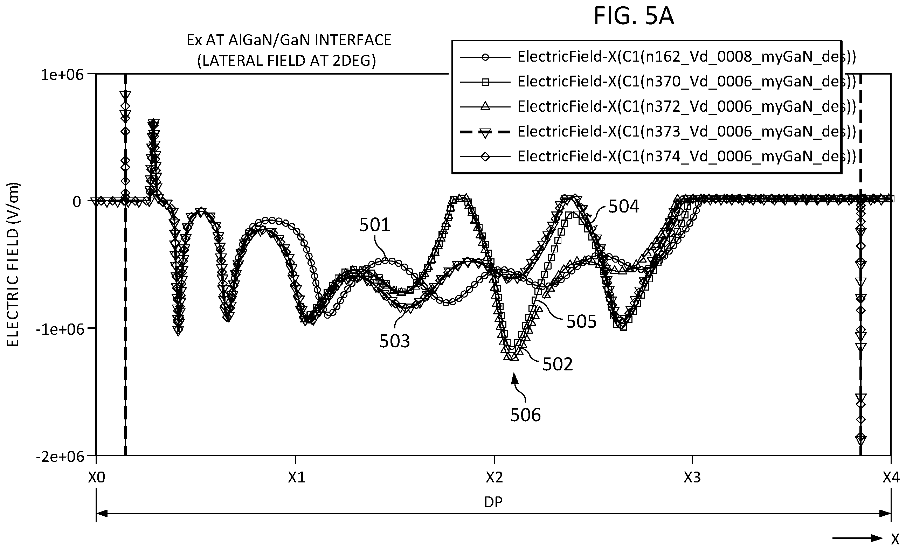

**FIG. 5A** illustrates plots 502-505 of lateral electric field Ex corresponding with GaN HEMT device structures 400a-d, respectively. Electric field Ex is plotted on the X-axis, showing X-coordinates X0-X4; and the Y-axis position may be the GaN/AlGaN interface Y-coordinate Yd. According to the teachings herein, large in magnitude, negative lateral electric field Ex may be desirable in the region of the field plates FP1-FP3; and increasing the magnitude of electric field Ex may advantageously impede acceleration of electrons in the lateral X-direction. Therefore, a more negative electric field Ex may better impede the formation of hot electrons.

Plot 501 may correspond with a reference device structure whereby all field plates FP1-FP3 extend to the same depth (i.e., to the surface of SiN layer 105). Plot 502 may correspond with device structure 400a. Plot 503 may correspond with device structure 400b. Plot 504 may correspond with device structure 400c; and plot 505 may correspond with device structure 400d.

By comparison, plots 502-505 show larger (i.e., greater magnitude) electric field Ex than that of plot 501. Of these, plots 502 and 505 have the largest (i.e., greatest magnitude) electric field Ex at negative peak 506. Additionally, the electric field Ex is negative and therefore repels electrons. Accordingly, using any one of HEMT device structures 400a-d may provide a structure which repels electrons (reduces the likelihood of hot carriers) more than that of the reference design structure of plot 501.

Overall, device structures 400a, 400d, corresponding with plots 502, 505, respectively, may offer the best performance as the magnitude of electric field Ex is greatest.

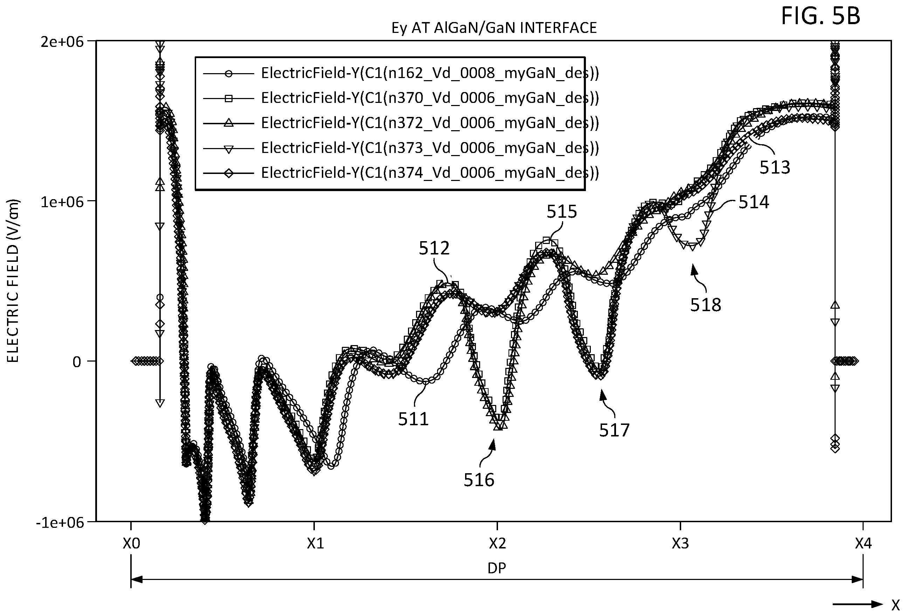

**FIG. 5B** illustrates plots 512-515 of vertical electric field Ey corresponding with GaN HEMT device structures 400a-d, respectively. Electric field Ey, as plotted on the X-axis, is the component of electric field in the Y-direction that may occur during hard switching. The Y-axis position may be the GaN/AlGaN interface Y-coordinate Yd. According to the teachings herein, large in magnitude, negative vertical electric field Ey may be desirable in the region of the field plates FP1-FP3; and increasing the magnitude of electric field Ey may advantageously impede acceleration of any hot electrons in the vertical direction. Accordingly, more negative electric field Ey may desirably improve device performance and prevent or reduce HCI.

Plot 511 may correspond with a reference device structure whereby all field plates FP1-FP3 extend to the same depth (i.e., to the surface of SiN layer 105). Plot 512 may correspond with device structure 400a. Plot 513 may correspond with device structure 400b. Plot 514 may correspond with device structure 400c; and plot 515 may correspond with device structure 400d.

By comparison, plots 512-515 show larger (i.e., greater magnitude) electric field Ey than that of plot 511. For instance, the vertical electric fields have large magnitude (large negative value) at negative peaks 516-518. Additionally, the electric field Ey is negative and therefore repels electrons. Accordingly, using any one of HEMT device structures 400a-d may provide a structure which repels electrons more than that of the reference design structure of plot 511.

Overall, device structure 400c, corresponding with plot 514, may provide best performance as only plot 514 shows the additional negative peak 518.

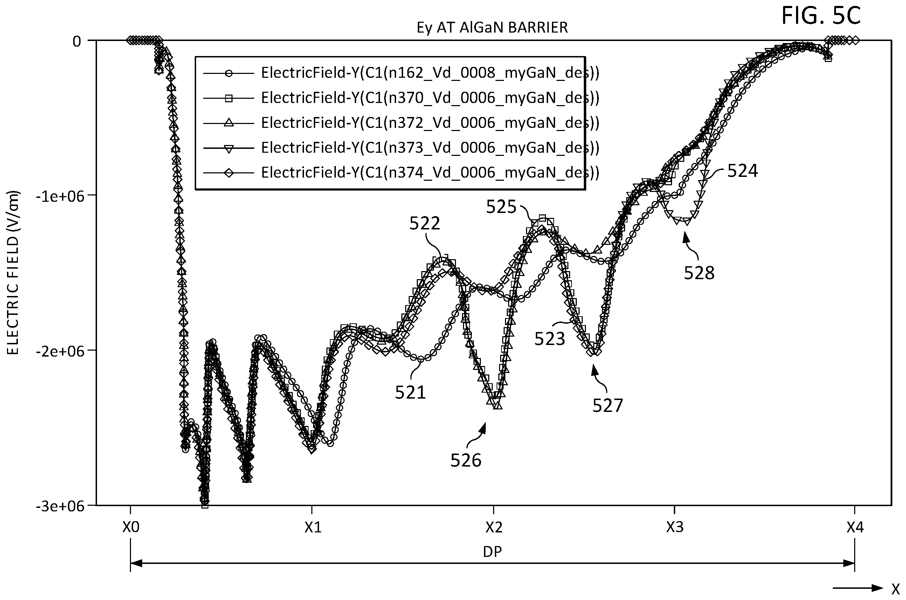

FIG. 5C illustrates plots 522-525 of vertical electric field Ey corresponding with GaN HEMT device structures 400a-d, respectively. Electric field Ey, as plotted on the X-axis, is the component of electric field in the Y-direction that may occur during hard switching. The Y-axis position may be the barrier Y-coordinate Y1.

Plot 521 may correspond with a reference device structure whereby all field plates FP1-FP3 extend to the same depth (i.e., to the surface of SiN layer 105). Plot 522 may correspond with device structure 400a. Plot 523 may correspond with device structure 400b. Plot 524 may correspond with device structure 400c; and plot 525 may correspond with device structure 400d.

By comparison, plots 522-525 show larger (i.e., greater magnitude) electric field Ey then that of plot 521. For instance, the vertical electric fields have large magnitude (large negative value) at negative peaks 526-528. Additionally, the electric field Ey is negative and therefore repels electrons. Accordingly, using any one of HEMT device structures 400a-d may provide a structure which repels electrons more than that of the reference design structure of plot 511.

Overall, device structure 400c, corresponding with plot 524, may provide best performance as only plot 524 shows the additional negative peak 528.

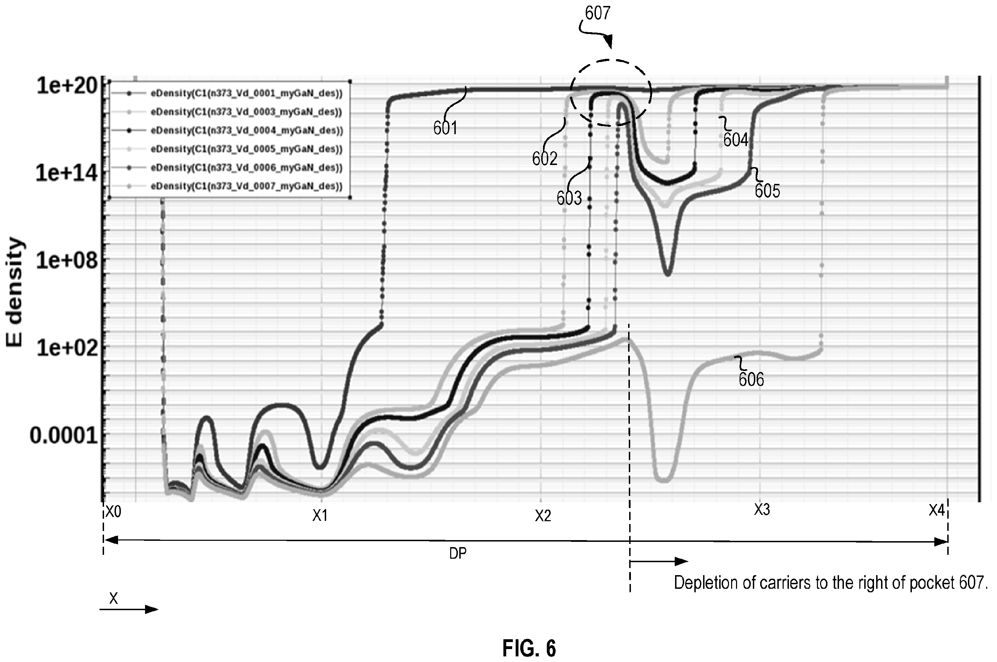

**FIG.** 6 illustrates plots 601-606 of electron density Ne corresponding with HEMT device structure 400c. Electron density Nc is plotted on the X-axis showing X-coordinates X0-X4; and Y-axis position may be the GaN/AlGaN interface Y-coordinate Yd. Thus, the electron density Ne may be that of the 2DEG 132.

Plot 601 may correspond with device operation when applied drain voltage VD equals three hundred volts (300V). Plot 602 may correspond with device operation when applied drain voltage VD equals seven hundred and eighty volts (780V). Plot 603 may correspond with device operation when applied drain voltage VD equals nine hundred seventy volts (970V). Plot 604 may correspond with device operation when applied drain voltage VD equals one thousand two hundred and ten volts (1210V). Plot 605 may correspond with device operation when applied drain voltage VD equals one thousand three hundred and eighty-two volts (1382V); and plot 606 may correspond with device operation when applied drain voltage VD equals one thousand seven hundred and five volts (1705V).

As illustrated, an electron pocket may form in region 607. With reference to HEMT device structure 400c, there may be a depletion of carriers from the gate field plate GFP2 towards drain metallization 112. The depletion region, as shown to the right of region 607, may support a blocking-mode voltage (e.g., a voltage VD applied to the drain metallization); and according to the teachings herein, the depletion region (i.e., the lack of electrons region), to the right of region 607, may occur in the 2DEG 132 so as to advantageously impede hot electron formation.

The above description presents non-limiting embodiments of HEMTs and HEMT device structures (e.g., device structures 200, 400a-d); and while specific device structures (e.g., device structures 200, 400a-d) are described herein for illustrative purposes, various modifications are possible without departing from the broader spirit and scope of the present disclosure.

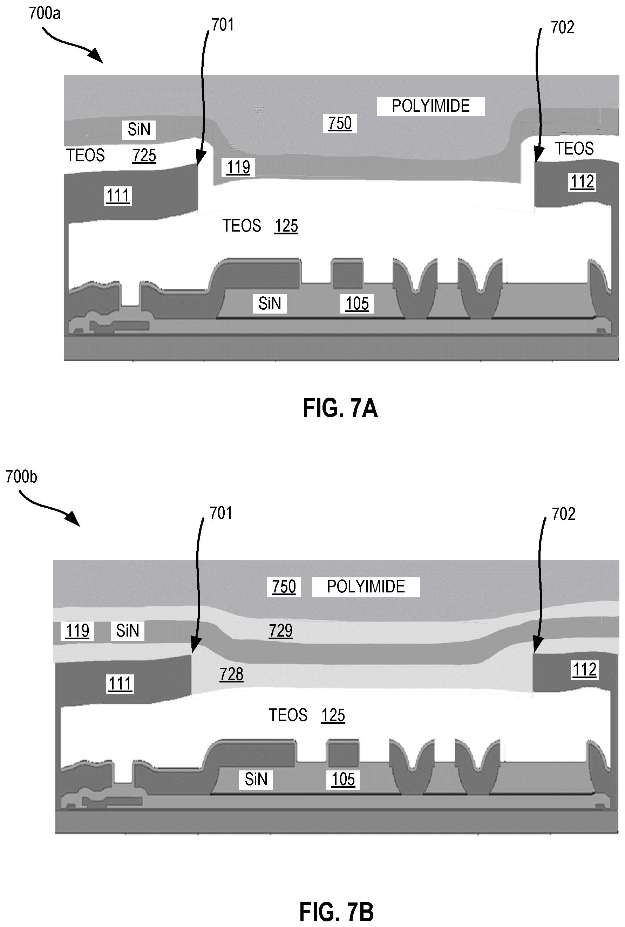

For instance, **FIG. 7A** illustrates a device cross section of a HEMT device structure 700a including additional passivation layers according to an embodiment of the present disclosure. HEMT device structure 700a is like HEMT device structure 200 except it includes an additional TEOS layer 725 between SiN layer 119 and source metallization 111 and between SiN layer 119 and drain metallization 112. Like TEOS layer 125, TEOS layer 725 may be deposited as a silicon dioxide film using chemical vapor deposition (e.g., plasma enhanced chemical vapor deposition).

Including TEOS layer 725 may advantageously improve reliability, including voltage dielectric breakdown robustness, by reducing stress mismatch between SiN layer 119 and source metallization 111 and between SiN layer 119 and drain metallization 112. For instance, source metallization 111 and drain metallization 112 may comprise aluminum (Al) which exhibits tensile stress while SiN layer 119 exhibits compressive stress; and TEOS layer 725 may buffer (i.e., reduce) the stress mismatch to improve layer characteristics by reducing pinholes and cracking, especially in the metallization corner regions 701, 702. Accordingly, TEOS layer 725 may also be referred to as a stress buffer layer.

Also, as illustrated, the HEMT device structure 700a includes polyimide layer 750. As one of skill in the art may appreciate, polyimide layer 750 together with SiN layer 119 may be a viable dual passivation; and SiN layer 119 may provide a barrier to moisture absorbed by polyimide layer 750. Including TEOS layer 725 may further improve the SiN layer 119 as a moisture barrier by reducing the stress mismatch as discussed above.

**FIG. 7B** also illustrates a device cross section of a HEMT device structure 700b including additional passivation layers according to another embodiment of the present disclosure. HEMT device structure 700b is also like HEMT device structure 200 except it includes a silicon oxynitride (SiON) layer 728 between SiN layer 119 and source metallization 111 and between SiN layer 119 and drain metallization 112. Additionally, HEMT device structure 700b includes a SiON layer 729 between polyimide layer 750 and SiN layer 119.

Including SiON layer 728 may, like TEOS layer 725, advantageously improve reliability, including voltage dielectric breakdown robustness, by reducing stress mismatch between SiN layer 119 and source metallization 111 and between SiN layer 119 and drain metallization 112. Accordingly, SiON layer 728 may also be referred to as a stress buffer layer.

Additionally, including SiON layer 729 may advantageously improve electric field profile so that a higher dielectric breakdown voltage may be achieved.

Reference throughout this specification to "one embodiment", "an embodiment", "one example" or "an example" means that a particular feature, structure or characteristic described in connection with the embodiment or example is included in at least one embodiment of a field plate placement for enhancing hard switching performance of a high electron mobility transistor (HEMT). Thus, appearances of the phrases "in one embodiment", "in an embodiment", "one example" or "an example" in various places throughout this specification are not necessarily all referring to the same embodiment or example. Furthermore, the particular features, structures or characteristics may be combined in any suitable combinations and/or subcombinations in one or more embodiments or examples. In addition, it is appreciated that the figures provided herewith are for explanation purposes to persons ordinarily skilled in the art and that the drawings are not necessarily drawn to scale.

Moreover, conditional language used herein, such as, among others, "can," "could," "might," "may," "e.g.," "for example," "such as" and the like, unless specifically stated otherwise or otherwise understood within the context as used, is generally intended to convey that certain embodiments include, while other embodiments do not include, certain features, elements and/or states. Thus, such conditional language is not generally intended to imply that features, elements and/or states are in any way required for one or more embodiments or that one or more embodiments necessarily include logic for deciding whether these features, elements and/or states are included or are to be performed in any particular embodiment.

The above description of illustrated examples of the present disclosure, including what is described in the Abstract, are not intended to be exhaustive or to be limitation to the precise forms disclosed. While specific embodiments of a field plate placement for enhancing hard switching performance of a high electron mobility transistor (HEMT) are described herein for illustrative purposes, various equivalent modifications are possible without departing from the broader spirit and scope of the present disclosure. Indeed, it is appreciated that the specific example device cross sections are provided for explanation purposes and that other embodiments may also be employed in accordance with the teachings herein.

### EMBODIMENTS

Although the present invention is defined in the attached claims, it should be understood that the present invention can also (alternatively) be defined in accordance with the following embodiments:
1. A high electron mobility transistor (HEMT) device structure comprising:
   a passivation layer;
   a gate field plate;
   a first quasi-floating field plate located laterally between the gate field plate and a drain interconnect metallization, wherein the first quasi-floating field plate extends to a first depth; and
   a second quasi-floating field plate located laterally between the first quasi-floating field plate and the drain interconnect metallization, wherein the second quasi-floating field plate extends to a second depth different from the first depth.
2. The HEMT device structure of embodiment 1, wherein the first quasi-floating field plate extends to a surface of the passivation layer.
3. The HEMT device structure of embodiment 1, wherein the second quasi-floating field plate extends to a surface of the passivation layer.
4. The HEMT device structure of embodiment 1, wherein the first quasi-floating field plate extends into the passivation layer.
5. The HEMT device structure of embodiment 1, wherein the second quasi-floating field plate extends into the passivation layer.
6. The HEMT device structure of embodiment 1, wherein the first quasi-floating field plate and the second quasi-floating field plate are electrically coupled to a capacitance network.
7. The HEMT device structure of embodiment 1, wherein the first quasi-floating field plate and the second quasi-floating field plate are electrically coupled to a bias network.
8. The HEMT device structure of embodiment 1, wherein the passivation layer is a silicon nitride (SiN) passivation layer.
9. The HEMT device structure of embodiment 1, wherein the gate field plate extends into the passivation layer.
10. The HEMT device structure of embodiment 1, wherein the gate field plate extends to a surface of the passivation layer.
11. The HEMT device structure of embodiment 1, wherein the first quasi-floating field plate and the second quasi-floating field plate are configured to distribute an electric field between the gate field plate and the drain interconnect metallization.
12. The HEMT device structure of embodiment 11, wherein a profile of the electric field is determined, at least in part, by the first depth and the second depth.
13. The HEMT device structure of embodiment 12, wherein the first depth and the second depth are selected so as to increase a magnitude of a peak electric field.
14. The HEMT device structure of embodiment 11, wherein the first depth and the second depth are selected so as to reduce a hot carrier injection (HCI) emanating from a two-dimensional electron gas.
15. The HEMT device structure of embodiment 1, further comprising a third quasi-floating field plate located laterally between the second quasi-floating field plate and the drain interconnect metallization.
16. The HEMT device structure of embodiment 15, wherein the third quasi-floating field plate extends to the first depth.
17. The HEMT device structure of embodiment 15, wherein the third quasi-floating field plate extends to the second depth.
18. The HEMT device structure of embodiment 15, wherein the first quasi-floating field plate, the second quasi-floating field plate, and the third quasi-floating field plate are electrically coupled to a capacitance network.
19. The HEMT device structure of embodiment 15, wherein the first quasi-floating field plate, the second quasi-floating field plate, and the third quasi-floating field plate are electrically coupled to a bias network.
20. A high electron mobility transistor (HEMT) device structure comprising:
   a first passivation layer;
   a second passivation layer above the first passivation layer;
   a first gate field plate, wherein the first gate field plate extends to a surface of the first passivation layer;
   a second gate field plate located laterally between the first gate field plate and a drain interconnect metallization, wherein the second gate field plate extends to a surface of the second passivation layer;
   a first quasi-floating field plate located laterally between the second gate field plate and the drain interconnect metallization, wherein the first quasi-floating field plate extends to a first depth; and
   a second quasi-floating field plate located laterally between the first quasi-floating field plate and the drain interconnect metallization, wherein the second quasi-floating field plate extends to a second depth different from the first depth.
21. The HEMT device structure of embodiment 20, wherein the first quasi-floating field plate extends to the surface of the first passivation layer.
22. The HEMT device structure of embodiment 20, wherein the first quasi-floating field plate extends to the surface of the second passivation layer.
23. The HEMT device structure of embodiment 20, wherein the second quasi-floating field plate extends to the surface of the first passivation layer.
24. The HEMT device structure of embodiment 20, wherein the second quasi-floating field plate extends to the surface of the second passivation layer.
25. The HEMT device structure of embodiment 20, wherein the first quasi-floating field plate and the second quasi-floating field plate are electrically coupled to a capacitance network.
26. The HEMT device structure of embodiment 20, wherein the first quasi-floating field plate and the second quasi-floating field plate are electrically coupled to a bias network.
27. The HEMT device structure of embodiment 20, further comprising a third quasi-floating field plate located laterally between the second quasi-floating field plate and the drain interconnect metallization.
28. The HEMT device structure of embodiment 27, wherein the third quasi-floating field plate extends to the surface of the first passivation layer.
29. The HEMT device structure of embodiment 27, wherein the third quasi-floating field plate extends to the surface of the second passivation layer.
30. The HEMT device structure of embodiment 27, wherein the first quasi-floating field plate, the second quasi-floating field plate, and the third quasi-floating field plate are electrically coupled to a capacitance network.
31. The HEMT device structure of embodiment 27, wherein the first quasi-floating field plate, the second quasi-floating field plate, and the third quasi-floating field plate are electrically coupled to a bias network.
32. The HEMT device structure of embodiment 27, wherein the first quasi-floating field plate, the second quasi-floating field plate, and the third quasi-floating field plate are configured to distribute an electric field between the second gate field plate and the drain interconnect metallization.
33. The HEMT device structure of embodiment 32, wherein a profile of the electric field is determined, at least in part, by the first depth and the second depth.
34. A high electron mobility transistor (HEMT) device structure comprising:
   a gate field plate;
   a first field plate located laterally between the gate field plate and a drain interconnect metallization, wherein the first field plate extends to a surface of a first passivation layer; and
   a second field plate located laterally between the first field plate and the drain interconnect metallization, wherein the second field plate extends to a surface of a second passivation layer having a different depth than that of the first passivation layer.
35. The HEMT device structure of embodiment 34, wherein the surface of the first passivation layer is above the surface of the second passivation layer.
36. The HEMT device structure of embodiment 34, wherein the surface of the first passivation layer is below the surface of the second passivation layer.
37. The HEMT device structure of embodiment 34, wherein the first field plate and the second field plate are electrically coupled to a capacitance network.
38. The HEMT device structure of embodiment 34, wherein the first field plate and the second field plate are electrically coupled to a bias network.
39. The HEMT device structure of embodiment 34, wherein the first passivation layer is a silicon nitride (SiN) passivation layer.
40. The HEMT device structure of embodiment 34, wherein the second passivation layer is a silicon nitride (SiN) passivation layer.
41. The HEMT device structure of embodiment 34, wherein the first field plate and the second field plate are configured to distribute an electric field between the gate field plate and the drain interconnect metallization.
42. The HEMT device structure of embodiment 34, further comprising a third field plate located laterally between the second field plate and the drain interconnect metallization.
43. The HEMT device structure of embodiment 42, wherein the third field plate extends to the surface of the first passivation layer.
44. The HEMT device structure of embodiment 42, wherein the third field plate extends to the surface of the second passivation layer.
45. The HEMT device structure of embodiment 42, wherein the first field plate, the second field plate, and the third field plate are electrically coupled to a capacitance network.
46. The HEMT device structure of embodiment 42, wherein the first field plate, the second field plate, and the third field plate are electrically coupled to a bias network.

## Claims

1. A high electron mobility transistor (HEMT) device structure comprising:
a passivation layer;
a gate field plate;
a first quasi-floating field plate located laterally between the gate field plate and a drain interconnect metallization, wherein the first quasi-floating field plate extends to a first depth; and
a second quasi-floating field plate located laterally between the first quasi-floating field plate and the drain interconnect metallization, wherein the second quasi-floating field plate extends to a second depth different from the first depth.

2. The HEMT device structure of claim 1, wherein either the first quasi-floating field plate or the second quasi-floating field plate extends to a surface of the passivation layer or extends into the passivation layer.

3. The HEMT device structure of any preceding claim, wherein the first quasi-floating field plate and the second quasi-floating field plate are electrically coupled either to a capacitance network or electrically coupled to a bias network.

4. The HEMT device structure of any preceding claim, wherein the passivation layer is a silicon nitride (SiN) passivation layer.

5. The HEMT device structure of any preceding claim, wherein the gate field plate extends either into the passivation layer or to a surface of the passivation layer.

6. The HEMT device structure of any preceding claim, further comprising a stress buffer layer.

7. The HEMT device structure of any preceding claim, wherein the first quasi-floating field plate and the second quasi-floating field plate are configured to distribute an electric field between the gate field plate and the drain interconnect metallization.

8. The HEMT device structure of claim 7, wherein a profile of the electric field is determined, at least in part, by the first depth and the second depth, and
optionally wherein the first depth and the second depth are selected to increase a magnitude of a peak electric field.

9. The HEMT device structure of claim 7, wherein the first depth and the second depth are selected to reduce a hot carrier injection (HCI) emanating from a two-dimensional electron gas.

10. The HEMT device structure of any preceding claim, further comprising a third quasi-floating field plate located laterally between the second quasi-floating field plate and the drain interconnect metallization, and
optionally wherein the third quasi-floating field plate extends either to the first depth or to the second depth.

11. The HEMT device structure of claim 10, wherein the first quasi-floating field plate, the second quasi-floating field plate, and the third quasi-floating field plate are electrically coupled to either i) a capacitance network, ii) a bias network, or iii) the capacitance network and the bias network.

12. A high electron mobility transistor HEMT) device structure comprising:
a first passivation layer;
a second passivation layer above the first passivation layer;
a first gate field plate, wherein the first gate field plate extends to a surface of the first passivation layer;
a second gate field plate located laterally between the first gate field plate and a drain interconnect metallization, wherein the second gate field plate extends to a surface of the second passivation layer;
a first quasi-floating field plate located laterally between the second gate field plate and the drain interconnect metallization, wherein the first quasi-floating field plate extends to a first depth; and
a second quasi-floating field plate located laterally between the first quasi-floating field plate and the drain interconnect metallization, wherein the second quasi-floating field plate extends to a second depth different from the first depth.

13. The HEMT device structure of claim 12, wherein:
- either the first quasi-floating field plate or the second quasi-floating field plate extends to the surface of the first passivation layer; or
- either the first quasi-floating field plate or the second quasi-floating field plate extends to the surface of the second passivation layer.

14. The HEMT device structure of claim 12 or 13, wherein the first quasi-floating field plate and the second quasi-floating field plate are electrically coupled to either i) a capacitance network, ii) a bias network, or iii) the capacitance network and the bias network.

15. The HEMT device structure of any one of claims 12-14, further comprising a third quasi-floating field plate located laterally between the second quasi-floating field plate and the drain interconnect metallization.
